(19) Europäisches Patentamt
European Patent Office
Office européen des brevets

(11) **EP 4 687 288 A1**

(12) **EUROPEAN PATENT APPLICATION**

(43) Date of publication:
**04.02.2026 Bulletin 2026/06**

(21) Application number: **25190660.8**

(22) Date of filing: **21.07.2025**

(51) International Patent Classification (IPC):
**H03K 3/037** (2006.01)   **H03K 19/094** (2006.01)
**G06F 7/58** (2006.01)

(52) Cooperative Patent Classification (CPC):
**H03K 19/09425; G06F 7/588; H03K 3/037**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **29.07.2024 US 202463676547 P**

(71) Applicant: **Extropic Corp.**
**Austin TX 78757 (US)**

(72) Inventors:
• **FREITAS, Jose Nahuel**
**Cambridge, 02139 (US)**
• **VERDON-AKZAM, Guillaume**
**San Francisco, 94133 (US)**
• **CHAMBERLAND, Christopher Abraham**
**Austin, 78748 (US)**
• **MCCOURT, Trevor Johnathan**
**Cambridge, 02139 (US)**

(74) Representative: **Piotrowicz, Pawel Jan Andrzej et al**
**Venner Shipley LLP**
**406 Cambridge Science Park**
**Milton Road**
**Cambridge CB4 0WW (GB)**

(54) **CIRCUITS FOR MIXING VOLTAGE DISTRIBUTIONS ASSOCIATED WITH RANDOM VARIABLE SAMPLES**

(57)    A method comprises: producing, using a first metastable circuit, a bistable state that varies over time between a first stable voltage and a second stable voltage, where a fraction of time that the bistable state spends at the first stable voltage is associated with a first probability; producing, using a first noise circuit, a first voltage distribution; producing, using a second noise circuit, a second voltage distribution; and producing, using a first mixer circuit, a third voltage distribution that is based at least in part on the bistable state, the first voltage distribution, and the second voltage distribution.

FIG. 7

EP 4 687 288 A1

# EP 4 687 288 A1

**Description**

CROSS-REFERENCE TO RELATED APPLICATION(S)

This application claims priority to and the benefit of U.S. Provisional Application Serial No. 63/676,547, entitled "CIRCUITS FOR MIXING VOLTAGE DISTRIBUTIONS ASSOCIATED WITH RANDOM VARIABLE SAMPLING," filed July 29, 2024.

TECHNICAL FIELD

This disclosure relates to circuits for mixing voltage distributions associated with random variable sampling.

BACKGROUND

Integrated circuits (ICs) comprising interconnected components including resistors, transistors, and capacitors can be used to build electronic devices capable of performing complex operations. Some IC devices can be utilized to build electronic devices that are capable of performing computations. Compact designs coupled with advances in mass production capabilities and technologies have contributed to the widespread adoption of ICs. Current implementations of IC devices utilize metal-oxide-semiconductor (MOS) integrated circuits that are built on chip platforms typically comprising silicon. Some IC devices can be built with complementary metal-oxide-semiconductors (CMOS) comprising semiconductors doped with elements to modify their associated physical properties.

SUMMARY

In one aspect, in general, an apparatus comprises: a first metastable circuit configured to produce a bistable state that varies over time between a first stable voltage and a second stable voltage, where a fraction of time that the bistable state spends at the first stable voltage is associated with a first probability; a first noise circuit configured to produce a first voltage distribution; a second noise circuit configured to produce a second voltage distribution; and a mixer circuit configured to receive the first voltage distribution, the second voltage distribution, and one or more signals based at least in part on the bistable state; wherein the mixer circuit is configured to produce a third voltage distribution that is based at least in part on the one or more signals associated with the bistable state, the first voltage distribution, and the second voltage distribution.

Aspects can include one or more of the following features.

The first metastable circuit is configured to produce the bistable state based at least in part on a bias voltage applied to the first metastable circuit.

Each of the first noise circuit and the second noise circuit comprises an inverter circuit.

Each inverter circuit of the first noise circuit and the second noise circuit comprises a p-type metal-oxide-semiconductor and an n-type metal-oxide-semiconductor transistor.

The one or more signals based at least in part on the bistable state comprise, at a given time, a signal based at least in part on the first stable voltage and a signal based at least in part on the second stable voltage.

The apparatus further comprises a level-shifter circuit configured to add a voltage to or subtract a voltage from the signal based at least in part on the first stable voltage and the signal based at least in part on the second stable voltage.

The mixer circuit comprises two active switching elements, where each active switching element of the two active switching elements is configured to act as a switch in the mixer circuit based on a respective applied voltage.

Each active switching element of the two active switching elements comprises one or both of a p-type metal-oxide-semiconductor transistor or an n-type metal-oxide-semiconductor transistor.

The respective applied voltage applied to each active switching element of the two active switching elements is lower than a threshold voltage of the one or both of the p-type metal-oxide-semiconductor transistor or the n-type metal-oxide-semiconductor transistor associated with that active switching element of the two active switching elements.

Each of the first voltage distribution and the second voltage distribution is associated with a respective distribution that is substantially Gaussian.

A fraction of time that the first metastable circuit spends at the second stable voltage is associated with a second probability that is related to the first probability.

The apparatus further comprises a plurality of metastable circuits including the first metastable circuit, wherein each metastable circuit of the plurality of metastable circuits is configured to produce a bistable state that varies over time between a first stable voltage and a second stable voltage, where a fraction of time that the bistable state spends at the first stable voltage is associated with a first probability; a plurality of noise circuits, wherein each noise circuit of the plurality of noise circuits is configured to produce a respective voltage distribution; and a plurality of mixer circuits configured to receive one or more voltage distributions and one or more signals based at least in part on a bistable state and produce a voltage distribution based at least in part on the one or more voltage distributions and the one or more signals based at least in part on a bistable state; wherein each mixer circuit of the plurality of mixer circuits receives a respective voltage distribution from a noise circuit of the plurality of noise circuits; wherein a first mixer circuit of the plurality of mixer circuits receives one or more signals based at least in part on the bistable state from the first metastable circuit of the plurality of metastable circuits and the first mixer circuit of the plurality of mixer circuits receives a voltage distribution from a noise circuit of the plurality of noise circuits; wherein each other mixer circuit of the plurality of mixer circuits is configured to receive one or more signals based at least in part on a bistable state from a respective metastable circuit of the plurality of metastable circuits; wherein each other mixer circuit of the plurality of mixer circuits receives an output from another mixer circuit of the plurality of mixer circuits.

At least one noise circuit of the plurality of noise circuits is configured to produce a distribution that is substantially Gaussian.

Each metastable circuit of the plurality of metastable circuits is connected to a respective level-shifter circuit configured to add a reference voltage to or subtract a reference voltage from the one or more signals based on the bistable state.

In another aspect, in general, a method comprises: producing, using a first metastable circuit, a bistable state that varies over time between a first stable voltage and a second stable voltage, where a fraction of time that the bistable state spends at the first stable voltage is associated with a first probability; producing, using a first noise circuit, a first voltage distribution; producing, using a second noise circuit, a second voltage distribution; and producing, using a first mixer circuit, a third voltage distribution that is based at least in part on the bistable state, the first voltage distribution, and the second voltage distribution.

Aspects can include one or more of the following features.

The first voltage distribution and the second voltage distribution are each substantially Gaussian.

The method further comprises producing, using a plurality of metastable circuits, a plurality of bistable states, where each bistable state of the plurality of bistable states varies over time between a respective first stable voltage and a respective second stable voltage, where a fraction of time that that bistable state of the plurality of bistable states spends at the first stable voltage is associated with a first probability; producing, using a plurality of noise circuits, a first plurality of voltage distributions; and producing, using a plurality of mixer circuits, a second plurality of voltage distributions, where each voltage distribution in the second plurality of voltage distributions is based at least in part on a bistable state of the plurality of bistable states, a voltage distribution from the first plurality of voltage distributions, and a voltage distribution produced by another mixer circuit of the plurality of mixer circuits.

Each noise circuit of the plurality of noise circuits is configured to produce a voltage distribution that is substantially Gaussian.

Each metastable circuit of the plurality of metastable circuits is connected to a respective level-shifter circuit configured to add a reference voltage to or subtract a reference voltage from one or more signals based on the bistable state.

Each mixer circuit of the plurality of mixer circuits comprises two active switching elements, where each active switching element of the two active switching elements is configured to act as a switch in the mixer circuit based on a respective voltage applied to each active switching element of the two active switching elements.

Each active switching element of the two active switching elements comprises one or both of a p-type metal-oxide-semiconductor transistor, or an n-type metal-oxide-semiconductor transistor.

The respective voltage applied to each active switching element of the two active switching elements is lower than a threshold voltage of the one or both of the p-type metal-oxide-semiconductor transistor or the n-type metal-oxide-semiconductor transistor associated with the each active switching element of the two active switching elements.

Aspects can have one or more of the following advantages.

Some implementations of the circuit architectures disclosed herein can be utilized to sample from a mixture of two or more probability distributions.

Other features and advantages will become apparent from the following description, and from the figures and claims.

BRIEF DESCRIPTION OF THE DRAWINGS

The disclosure is best understood from the following detailed description when read in conjunction with the accompanying drawing. It is emphasized that, according to common practice, the various features of the drawing are not to-scale. On the contrary, the dimensions of the various features are arbitrarily expanded or reduced for clarity. The plots resulting from numerical simulations, as indicated below, are working examples of experimental results associated with some of the techniques described herein, and other plots are prophetic examples of expected experimental results.

FIGS. **1A-1B** are schematic diagrams of example circuit architectures.

FIGS. **2A-2D** are schematic diagrams of example p-bit circuits.

FIGS. **3A-3E** are schematic diagrams of example CMOS transistors.

FIG. **4** is a schematic diagram of an example t-gate multiplexer circuit.

FIG. **5** is a schematic diagram of an example level-shifter circuit.

FIG. **6** is a schematic diagram of an example noise circuit.

FIG. **7** is a schematic diagram of an example circuit architecture.

FIGS. **8A-8G** are plots of numerical simulations related to an example circuit architecture.

FIG. **9** is a schematic diagram of an example circuit architecture.

FIG. **10** is a schematic diagram of an example circuit architecture.

FIG. **11** is a schematic diagram of a flowchart of an example method.

DETAILED DESCRIPTION

Some integrated circuits can be operated in regime wherein fundamental thermodynamic processes characterize their behavior. In some examples, this operation can comprise driving a transistor in an integrated circuit using a voltage that is below a threshold voltage associated with the transistor such that the transistor is operating in the "sub-threshold regime" or below the sub-threshold limit. By way of example, some transistors operating in the sub-threshold regime can be driven at voltages between 0 mV and 175 mV. Some electronic devices comprising these transistors can harness thermodynamic processes to perform operations or computations.

Some ICs can comprise n-type metal-oxide-semiconductor (nMOS) or p-type metal-oxide-semiconductor (pMOS) transistors. nMOS transistors comprise semiconductors doped with an electron donor element, such as phosphorus, arsenic or antimony. pMOS transistors comprise semiconductors doped with an electron acceptor element such as boron, aluminum, or gallium.

A complementary metal-oxide-semiconductor (CMOS)-based circuit architecture, i.e., an apparatus, operating in a sub-threshold regime can be configured to sample from a mixture of two or more one-dimensional probability distributions. Such circuit architectures can comprise one or more subcircuits that are each configured to produce a distribution of voltages according to some probability distribution. In some examples, this probability distribution of voltages can approximate a Gaussian distribution. Some circuit architectures can further comprise one or more subcircuits that are each configured to produce a stable voltage over a period of time according to a probability. Some circuit architectures can combine these different types of subcircuits such the circuit architecture can sample from a Gaussian mixture model (GMM).

A GMM can be defined as a weighted sum of Gaussian components given by

$$p(x) = \sum_{i=1}^{K} \pi_i \mathcal{N}(x|\mu_i, \sigma_i^2), \qquad (1)$$

where $\pi_i$ are the mixture weights (which sum to 1), $\mu_i$ are the means and $\sigma_i^2$ are the variances of the Gaussian components. By adjusting the $\pi_i$, $\mu_i$ and $\sigma_i^2$ parameters, the mixture can be made to approximate any target distribution. Techniques such as the Expectation-Maximization (EM) algorithm can be employed to fit the parameters of the GMM to data from the target distribution, effectively allowing the GMM to approximate the underlying distribution. Once a GMM is fitted to approximate the target distribution, sampling from the GMM can be done in the following steps

- Sample a component i according to the mixture weights $\pi_i$.

- Sample from the chosen Gaussian component $\mathcal{N}(x|\mu_i, \sigma_i^2)$.

By repeating the above steps, samples from the Gaussian mixture can be obtained, which in turn approximates samples from the original distribution.

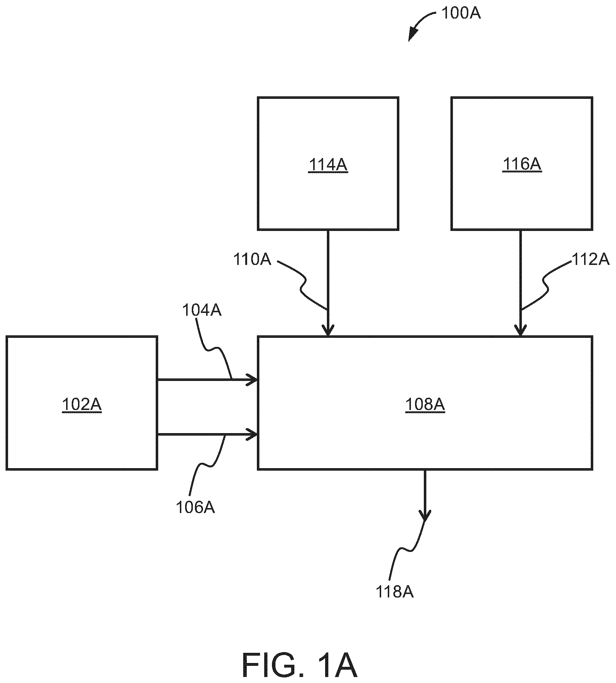

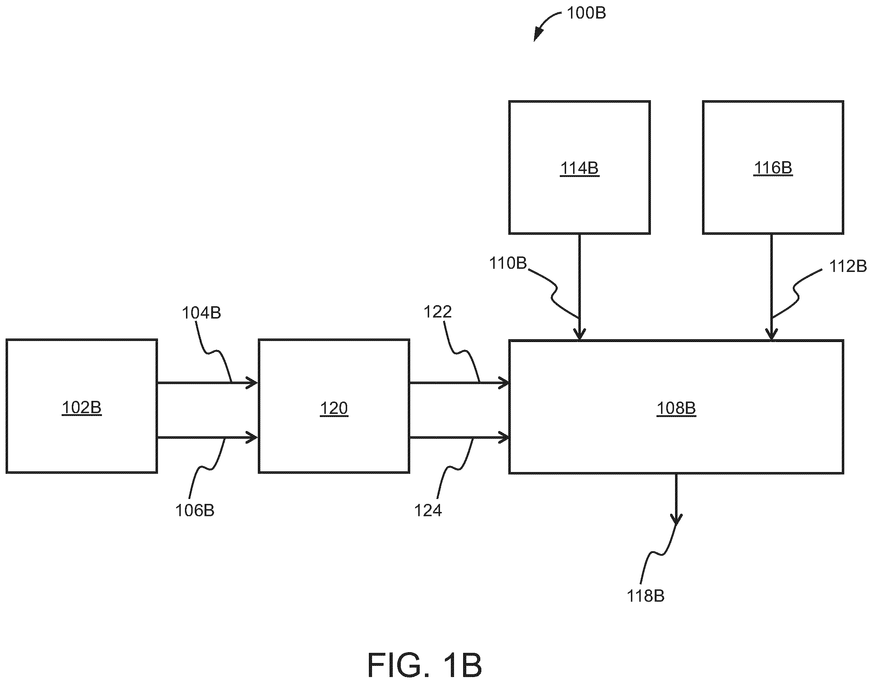

FIG. 1A depicts an example circuit architecture 100A and FIG. 1B depicts an example circuit architecture 100B that can be used sample from a mixture of probability distributions. The circuit architecture 100A comprises a first metastable circuit 102A having a first output node 104A and a second output node 106A. The first output node 104A and the second output node 106A are associated with a first bistable state that varies over time between a first stable voltage and a second stable voltage. A fraction of time that the first bistable state spends at the first stable voltage is associated with a first probability $p$ and a fraction of time that the first bistable state spends at the second voltage is associated with a second probability $1 - p$ that is related to the first probability. A mixer circuit 108A is configured to receive the first output node 104A and the second output node 106A, as well as an output 110A from a first noise circuit 114A and an output 112A from a second noise circuit 116A. Each of the first noise circuit 114A and the second noise circuit 116A is configured to produce a respective first voltage distribution and second voltage distribution to the output 110A and the output 112B, respectively. In other words, the mixer circuit 108A is configured to receive one or more signals associated with the first bistable state, the first voltage distribution, and the second votlage distribution. In some examples, as discussed later, each of the first voltage distribution and the second voltage distribution can be a continuous distribution over a range of voltages. The mixer circuit 108A is configured to produce a third voltage distribution to an output 118A, where the third voltage distribution is based at least in part on the first probability, the second probability, the first voltage distribution, and the second voltage distribution. In other words, the circuit architecture 100A is configured to stochastically mix a binary source of noise from a metastable circuit and two continuous sources of noise from the noise circuits. In some examples, as described later, a circuit can mix more than two continuous sources of noise. In some circuit architectures the metastable circuit can be associated with one or more input voltages (not shown).

As shown in FIG. 1B, the circuit architecture 100B comprises a metastable circuit 102B having a first output node 104B and a second output node 106B, a first noise circuit 114B, and a second noise circuit 116B, and mixer circuit 108B. Circuit architecture 100B also includes a level-shifter circuit 120 configured to receive a voltage or signal from each of the first output node 104B and the second output node 106B and produce an output 122 and an output 124 that are each based at least in part on the voltages from the first output node 104B and the second output node 106B, respectively. In other words, the level-shifter circuit 120 is configured to shift one or more signals based at least in part on a bistable state. Each of the first noise circuit 114B and the second noise circuit 116B is configured to produce a respective first voltage distribution and second voltage distribution to an output 110B and an output 112B, respectively. The mixer circuit 108B receives the output 122, the output 124, the output 110B from the first noise circuit 114B, and the output 112B from the second noise circuit 116B. The mixer circuit 108B is configured to output, to an output 118B, a third voltage distribution that is based at least in part on the first probability, the second probability, the first voltage distribution, and the second voltage distribution.

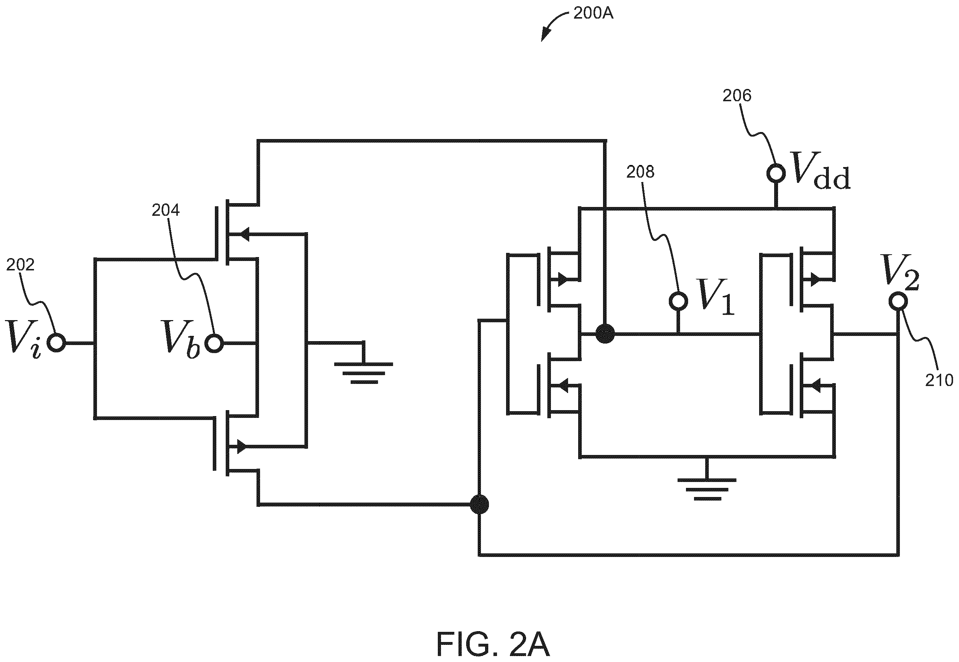

In some circuit architectures, the metastable circuit can be a probability bit circuit, also known as a $p$-bit. An example circuit 200A that can be used as a $p$-bit, i.e., to produce a bistable state, is shown in FIG. 2A. The circuit 200A comprises a terminal 202, a terminal 204, a terminal 206, a terminal 208, and a terminal 210 each associated with respective voltages $V_i$, $V_b$, $V_{dd}$, $V_1$, and $V_2$. For fixed voltages $V_{dd}$, $V_b$ and $V_i$, the state of the $p$-bit at the terminal 208 and the terminal 210 comprises the output voltages $\boldsymbol{V} = (V_1, V_2)$. The $p$-bit is a bistable circuit with two metastable states $\boldsymbol{V}_x \simeq (0, V_{dd})$ and $\boldsymbol{V}_y \simeq (V_{dd}, 0)$. At steady state, the $p$-bit can be in the metastable state $\boldsymbol{V}_x$ with probability $p$, or in the metastable state $\boldsymbol{V}_y$ with probability $1 - p$. In other words, at any given time, the circuit produces, at any given time, a signal based at least in part on a first stable voltage and a signal based at least in part on a second stable voltage. The particular value of $p$ is controlled by the input voltage $V_i$. When $V_i$ approaches $V_{dd}$, $p$ tends to 1, and when $V_i$ approaches $0$, $p$ tends to 0. The precise relationship between $p$ and $V_i$ can be tuned by the biasing voltage $V_b$.

In some implementations, external circuitry can be configured to interact with a circuit architecture or a circuit, or portions thereof. For instance, some external circuitry can interact with a circuit architecture by applying voltages to or reading voltages from a circuit architecture or portions thereof. For instance, control circuitry can be configured to apply control signals or generate voltages to be applied to a circuit. In some examples, readout circuitry configured to read, sample, and/or store voltages from a circuit. In some implementations, circuitry configured to apply control signals to a circuit architecture, or portions thereof, can be positioned on a separate integrated circuit chip or device as the circuit architecture. In some examples, control signals applied to a circuit or signals produced by a circuit can be weak. In some implementations, to mitigate weak signals, circuitry configured to apply control signals to a circuit architecture, or portions thereof, can be positioned in proximity to the circuit architecture, i.e., on the same integrated circuit chip or device that comprises the circuit architecture. In some implementations, circuitry configured to readout signals from a circuit architecture, or portions thereof, can be positioned in proximity to the circuit architecture, i.e., on the same integrated circuit chip or device that comprises the circuit architecture. Positioning one or both of the readout circuitry or the control circuitry in proximity to a circuit architecture can be useful to mitigate losses associated with transmitting weak signals over larger distances.

In other words, the *p*-bit shown in FIG. 2A includes a first output node, i.e., the terminal 208, that is associated with a first bistable state that varies over time between a first stable voltage, i.e., $V_0$, and a second stable voltage, i.e., $V_{dd}$, where a fraction of time that the first bistable state spends at the first stable voltage, i.e., $V_0$, is associated with a first probability *p*. The *p*-bit also includes a second output node, i.e., the terminal 210, that is associated with the first bistable state that varies over time between the second stable voltage, i.e., $V_{dd}$ and the first stable voltage, i.e., $V_0$, where a fraction of time that the first bistable state spends at the second stable voltage, i.e., $V_{dd}$, is associated with a second probability 1 - *p*.

In the example circuit 200A, bistable behaviour is generated by the right-hand portion of the circuit, which consists of two-coupled NOT gates as in some static random-access memory (SRAM) cells. In some bistable circuits, a powering voltage $V_{dd}$ can be above a critical value $V_{dd}^*$, which for the case in which all transistor have exactly the same parameters and the subtreshold slope is *n* = 1 takes the value $V_{dd}^* = V_T \ln 2$, where $V_T = k_b T / q_e$ is the thermal voltage.

In some examples, random transitions between two metastable nonequilibrium steady states can occur with a transition rate that depends on the power voltage $V_{dd}$. In some examples, frequent random transitions can be expected whenever the standard deviation of the fluctuations around the output voltage $\sigma_V = \sqrt{k_b T / C}$ is comparable to the mean value $\langle V_1 - V_2 \rangle \approx \pm V_{dd}$, In this equation, C is the typical capacitance value at the output nodes. Hence, these transitions can be controlled by changing the powering voltage $V_{dd}$ or for fixed $V_{dd} > V_{dd}^*$, by changing the temperature or size of the transistors, since the size of a transistor can affect the typical capacitance *C*.

The biasing of a circuit state associated with the example circuit 200A is achieved by the left-most component. The bias voltage $V_b > 0$ is coupled to the outputs of the two inverters which form the core of the example *p*-bit through the drain-source channel of two transistors. The pMOS transistor influences the output of the first inverter while a nMOS transistor influences the output of the second inverter. When $V_i \simeq V_{dd}/2$, both transistors are equally activated and both outputs are very weakly biased towards $V_b$. For $V_i \rightarrow 0$, conduction through the pMOS transistor is enhanced, while conduction is suppressed through the nMOS. As such, only the output of the first inverter is biased towards $V_b$. The symmetry between the two possible metastable NESSs is broken, with $V_1 \approx V_{dd}$ being favored. The situation is reversed for $V_i \rightarrow V_{dd}$.

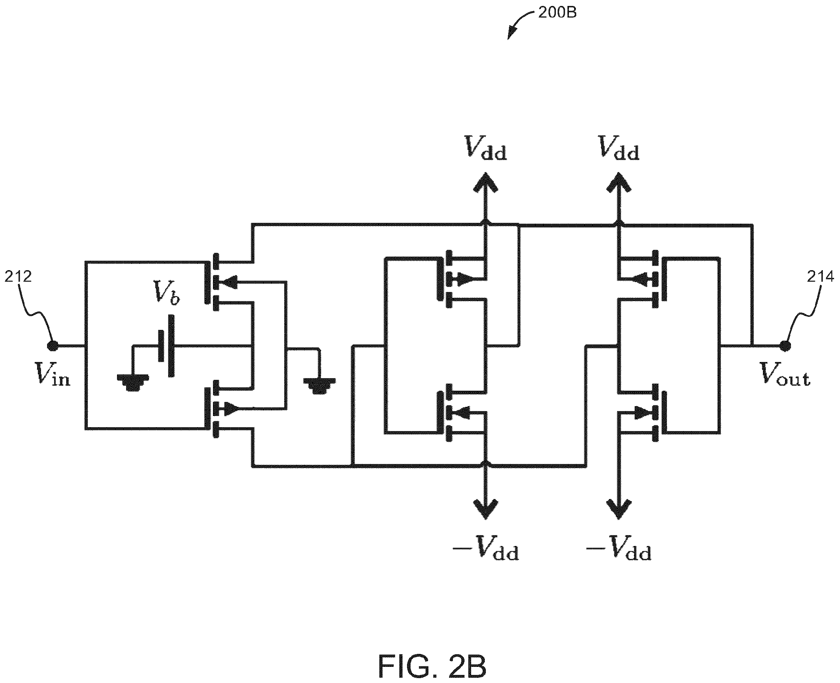

The circuit 200A comprises two outputs. Some *p*-bits can comprise one output. FIG. 2B depicts an example circuit 200B that can be used as a *p*-bit, i.e., to produce a bistable state,. The circuit 200B comprises pMOS and nMOS transistors, an input terminal 212 associated with a voltage $V_{in}$, an output terminal 214 associated with a voltage $V_{out}$, and terminals associated with voltages $V_{dd}$. The circuit 200B is configured to receive a bias voltage $V_b$. At steady state, the output terminal 214 can be in the metastable state $V_{out} = V_{dd}$ with probability *p*, or in the metastable state $V_{out} = -V_{dd}$ with probability 1 - *p*.

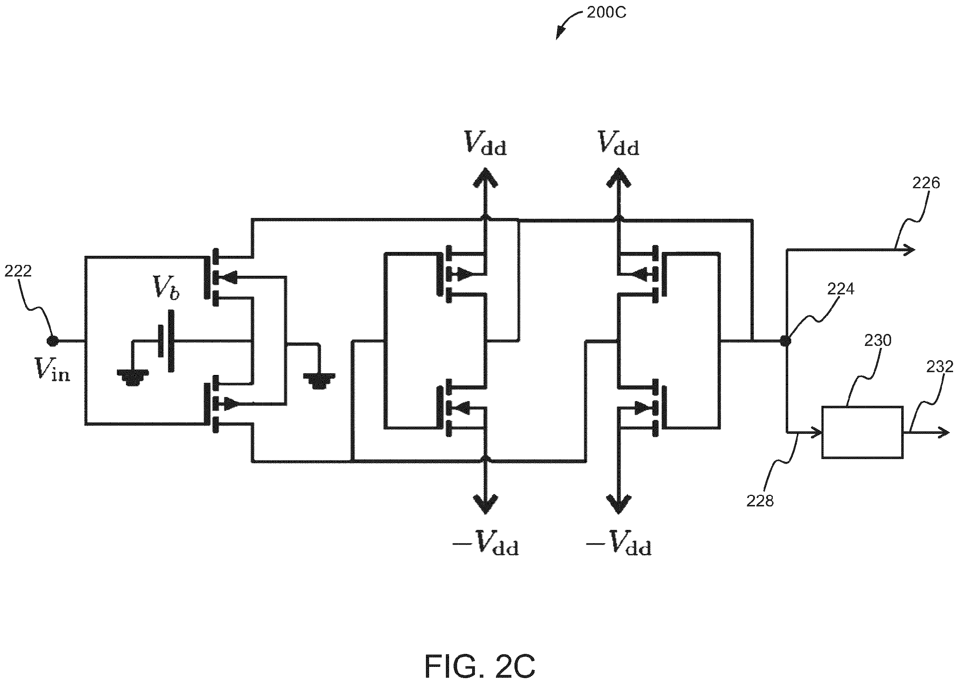

In some examples, the output of a *p*-bit circuit can be split into a first output and a second output and each of the first output and the second output can be directed to other circuitry. FIG. 2C depicts an example circuit 200C comprising a similar configuration as the circuit 200B shown in FIG. 2B. The circuit 200C comprises pMOS and nMOS transistors, an input terminal 222 associated with a voltage $V_{in}$, an output terminal 224 associated with a voltage $V_{out}$, and terminals associated with voltages $V_{dd}$. The circuit 200C is configured to receive a bias voltage $V_b$. At steady state, the output terminal 224 can be in the metastable state $V_{out} = V_{dd}$ with probability *p*, or in the metastable state $V_{out} = -V_{dd}$ with probability 1 - *p*. The output at the output terminal 224 is split into a first signal 226 and a second signal 228, i.e., signals based on the metastable state. The second signal 228 is directed to an inverter circuit 230 to produce an inverted signal 232. In other words, the inverted signal 232 and the first signal 226 are both based on the metastable state.

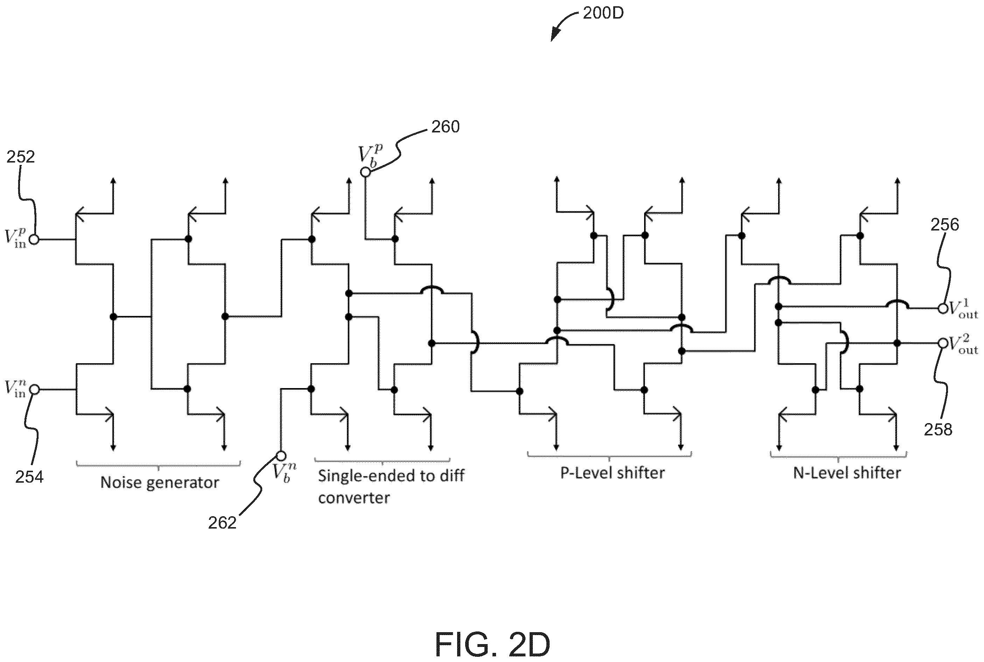

An example circuit 200D that can be used as a *p*-bit is shown in FIG. 2D. The circuit 200D comprises a first input 252, a second input 254, a first output 256, and a second output 258. The first input 252 is associated with a voltage $V_{in}^p$, the second input 254 is associated with a voltage $V_{in}^n$ the first output 256 is associated with a voltage $V_{out}^1$, and the second output 258 is associated with a voltage $V_{out}^2$. The circuit 200D also has a bias 260 associated with a voltage $V_b^p$ and a bias 262 associated with a voltage $V_b^n$ that can be used to control the first output 256 and the second output 258. The bias 260 and the bias 262 can be used to address variations in transistor parameters that can occur during the fabrication process. The component of the circuit 200D labeled "Single-ended to diff converter" can take the noise generated from the first module and outputs two noisy signals that can be anticorrelated. The circuit 200D also comprises a *P*-level shifter that can shift voltages upwards and a *N*-level shifter that can shift voltages downwards.

In some circuit architectures, the mixer circuit can comprise a *t*-gate multiplexer that can be configured to mix input distributions. In some examples, a *t*-gate multiplexer can comprise two or more *t*-gates, where a *t*-gate comprises one or more transistors and can effectively act as a switch when operating in the sub-threshold regime. In some examples, a *t*-gate can also be referred to as an active switching element.

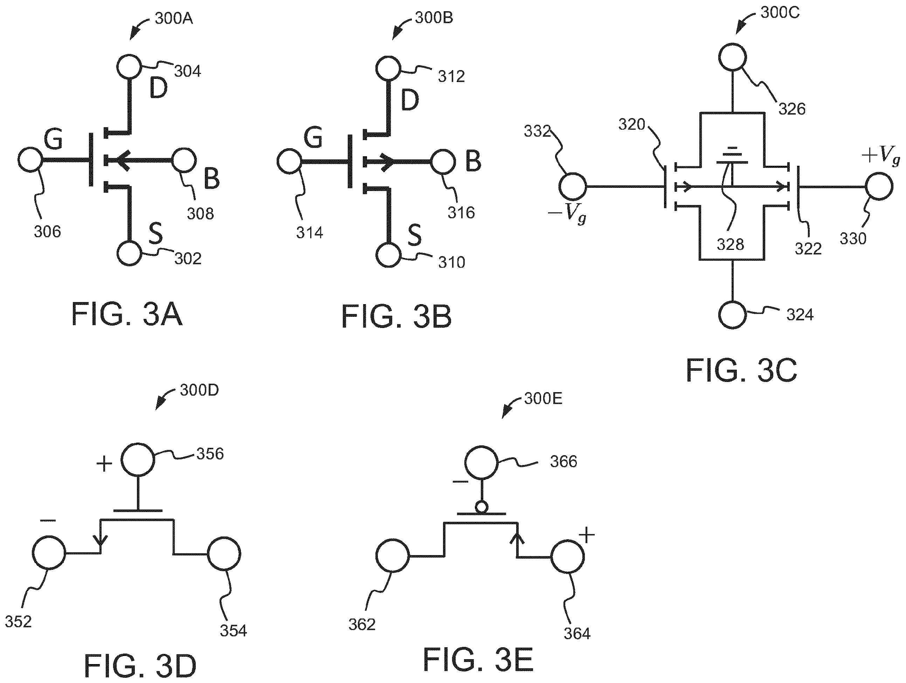

FIGS. 3A-3E depict example circuits that can be utilized as a *t*-gate. FIG. 3A depicts an nMOS transistor 300A comprising a source terminal 302 associated with a voltage $V_S$, a drain terminal 304 associated with a voltage $V_D$, a gate terminal 306 associated with a voltage $V_g$, and a body terminal 308. Some nMOS transistors can comprise three terminals rather than four terminals. An example nMOS transistor 300D comprising three terminals is depicted in FIG. 3D. The nMOS transistor 300D comprises a source terminal 352 associated with a voltage $V_S$, a drain terminal 354 associated with a voltage $V_D$, and a gate terminal 356 associated with a voltage $V_g$. nMOS transistors typically have positive threshold voltages $V_T$. An nMOS transistor can act as a short, or conduct, when $V_g$ -$V_S$ > $V_T$ and act as open circuits when $V_g$ -$V_S$ < $V_T$. nMOS transistors can have $V_D$ > $V_S$ and can source current to the load. The voltage $V_S$ associated with the source terminal 302 or the source terminal 352 can be low (near or at ground) to ensure the above conditions can easily be satisfied.

FIG. 3B depicts a pMOS transistor 300B comprising a source terminal 310 associated with a voltage $V_S$, a drain terminal 312 associated with a voltage $V_D$, a gate terminal 314 associated with a voltage $V_g$, and a body terminal 316. Some pMOS transistors can comprise three terminals rather than four terminals. An example pMOS transistor 300E comprising three terminals is depicted in FIG. 3E. The pMOS transistor 300E comprises a source terminal 362 associated with a voltage $V_S$, a drain terminal 364 associated with a voltage $V_D$, a gate terminal 366 associated with a voltage $V_g$. pMOS transistors typically have negative threshold voltages (i.e. $V_T$ < 0). A pMOS transistor can act as a short, or conduct, when $V_g$ -$V_S$ < -|$V_T$| and act as an open circuit when $V_g$ - $V_S$ > -|$V_T$|. For pMOS transistors, $V_S$ can be large to ensure that $V_g$ - $V_S$ conditions can more easily be satisfied. In addition, pMOS transistors can have $V_D$ < $V_S$ such that current is sunk from the load to the source. By tuning the source and gate voltages of nMOS and pMOS transistors, a circuit can thus act as a short or open circuit.

Some *t*-gate circuits can combine nMOS and pMOS transistors. FIG. 3C depicts a circuit 300C that can act as a *t*-gate comprising a pMOS transistor 320 having four terminals and an nMOS transistor 322 having four terminals, where the source terminals are connected at a node 324 and the drain terminals are connected at a node 326. The body terminals of the pMOS transistor 320 and the nMOS transistor 322 are connected to a ground 328. For the nMOS transistor 322, $V_g$ can be applied to the gate terminal 330 while for the pMOS transistor 320, -$V_g$ can be applied to the gate terminal 332.

By way of example, some transistors operating in a sub-threshold limit can be driven at voltages between 0 mV and 175 mV.

The circuits 300A-300E can behave as tunable non-linear resistors. Without intending to be bound by theory, the following is an example of a theoretical model for illustrating features. The current $I_{DS}$ from drain to source is given by

$$\frac{I_{DS}}{e} = \lambda_{DS} - \lambda_{SD} = 4\lambda_0 e^{\frac{U_g}{n}} \cosh U_\Sigma \sinh U_\Delta, \qquad (2)$$

where $U_g = V_g/V_T$ and

$$U_\Sigma = \frac{U_D + U_S}{2} \qquad (3)$$

$$U_\Delta = \frac{U_D - U_S}{2} \qquad (4)$$

with $U_\Sigma, U_\Delta$ < 1. In the above, $\lambda_{DS}$ and $\lambda_{SD}$ represent transition rates from drain to source and from source to drain. The transition rate can be associated with the probability per unit time of electron hopping, from drain to source and from source to drain. In deriving eq. (2), the symmetry of the circuit was used to write $\lambda_{DS} = \lambda_{DS}^{pMOS} + \lambda_{DS}^{nMOS}$ and $\lambda_{SD} = \lambda_{SD}^{pMOS} + \lambda_{SD}^{nMOS}$ where for a pMOS transistor,

$$\lambda_{DS}^{pMOS} = \lambda_0 e^{\frac{U_B - U_G}{n}} e^{U_D - U_B} \qquad (5)$$

$$\lambda_{SD}^{pMOS} = \lambda_0 e^{\frac{U_B - U_G}{n}} e^{U_S - U_B}. \qquad (6)$$

Similarly, for an nMOS transistor,

$$\lambda_{\text{DS}}^{\text{nMOS}} = \lambda_0 e^{\frac{U_G - U_B}{n}} e^{U_B - U_S} \tag{7}$$

$$\lambda_{\text{SD}}^{\text{nMOS}} = \lambda_0 e^{\frac{U_G - U_B}{n}} e^{U_B - U_D}. \tag{8}$$

For completeness,

$$\lambda_{\text{DS}} + \lambda_{\text{SD}} = 4\lambda_0 e^{\frac{U_g}{n}} \cosh U_\Sigma \cosh U_\Delta, \tag{9}$$

and

$$U_\Delta = \frac{e^{-\frac{U_g}{n}}}{4e\lambda_0} I_{\text{DS}}, \tag{10}$$

where the term $\frac{e^{-\frac{U_g}{n}}}{4e\lambda_0} \sim R$ can be interpreted as an effective resistance. From eqs. (2) and (10), when $V_g \gg 1$, the effective resistance is near zero and thus the circuit 300C behaves as a short circuit. On the other hand, when $V_g$ has a large negative value, the effective resistance is very large and thus the circuit 300C behaves as an open circuit. Consequently, a switch can be built out of two transistors. Such considerations for the voltages $V_g$ for closed vs open circuits determines important time scales for the dynamics of the circuit. To obtain a short circuit, $\lambda_0 e^{\frac{U_g}{n}}$ must be much greater than the effective transition rates for the other circuit components to which the circuit 300C is connected as module.

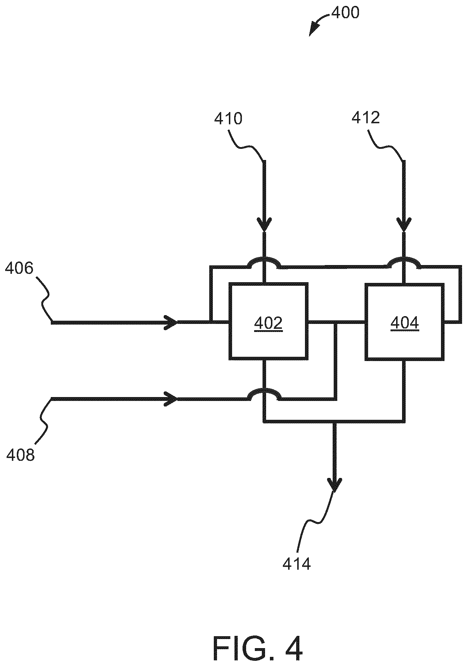

FIG. 4 depicts an example $t$-gate multiplexer circuit 400 comprising a $t$-gate 402 and a $t$-gate 404. In some $t$-gate multiplexer circuits, each of the $t$-gate 402 and the $t$-gate 404 can comprise any of the circuits 300A-300E. The $t$-gate multiplexer circuit 400 has an input node 406, an input node 408, an input node 410, an input node 412, and an output node 414. In some circuit architectures, the input node 406 and the input node 408 can be connected to outputs associated with a $p$-bit circuit and can be used to control which of the $t$-gate 402 and the $t$-gate 404 act as a short or open circuit. The input node 410 and the input node 412 can each be connected to respective noise circuit such that input voltages to the $t$-gate 402 and the $t$-gate 404 are associated with some probability distribution, i.e., a continuous distribution of voltages, determined by the noise circuit. The output node 414 can be associated with a voltage distribution that is a mixture of both input distributions from the input node 410 and the input node 412, with a particular weight attributed to each distribution that is dependent on the state of the $t$-gate 402 and the $t$-gate 404. The $t$-gate 402 and the $t$-gate 404 are both controlled by the state of the $p$-bit circuit, i.e., a bistable state, connected to the input node 406 and the input node 408.

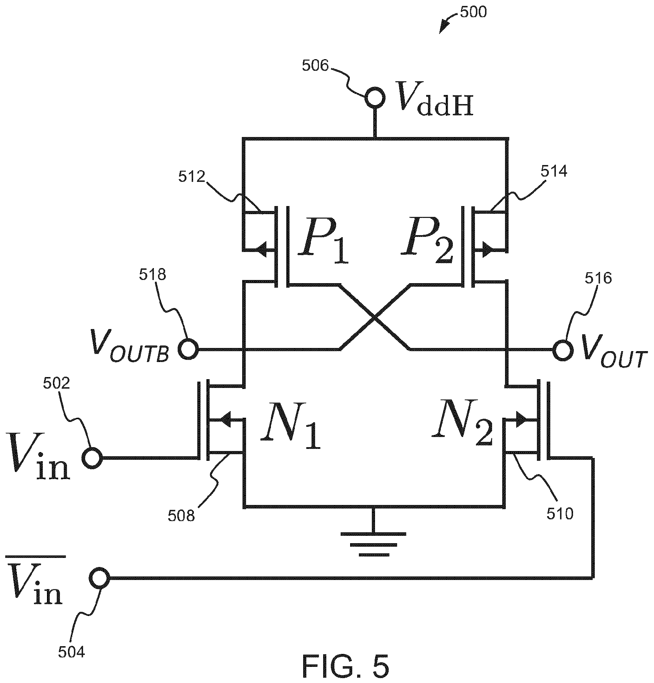

In some circuit architectures, output voltages associated with a $p$-bit circuit might not be large enough to drive a $t$-gate to which the $p$-bit circuit is connected. As shown in FIG. 1B, a level-shifter circuit can be added to the outputs of a $p$-bit circuit in order to amplify or shift respective output voltages associated with the $p$-circuit. In some examples, a level-shifter circuit can be configured to translate the input voltages based on a reference voltage, i.e., add a reference voltage to or subtract a reference voltage from the input voltages. An example circuit 500 configured as a level-shifter circuit is depicted in FIG. 5. The circuit 500 comprises an input port 502 associated with an input voltage $V_{in}$, an input port 504 associated with an input voltage $\overline{V_{in}}$, and a terminal 506 associated with a voltage $V_{ddH}$. The circuit 500 comprises a first nMOS transistor 508, a second nMOS transistor 510, a first pMOS transistor 512, and a second pMOS transistor 514. In other words, the circuit 500 comprises two cross-coupled nMOS driver transistors and two pMOS latches. An output node 516 and an output node 518 are each associated with voltages $V_{OUT}$ and $V_{OUTB}$ respectively. When the voltages $V_{in}$ and $\overline{V_{in}}$ are low and high, the first nMOS transistor 508 is off and the second nMOS transistor 510 is on. The second nMOS transistor 510 then pulls down $V_{OUT}$, causing the first pMOS transistor 512 to turn on, which in turn results in $V_{OUTB}$ increasing to $V_{ddh}$ and also causes the second pMOS transistor 514 to turn off. When the second pMOS transistor 514 is off, $V_{OUT}$ drops to ground. The opposite happens when the voltages $V_{in}$ and $\overline{V_{in}}$ are high and low, resulting in $V_{OUT}$ being at the voltage $V_{ddh}$.

In some examples, $V_{OUT}$ is determined by the drive currents of the second pMOS transistor 514, sometimes referred to as a pull-up transistor, and the second nMOS transistor 510, sometimes referred to as a pull-down transistor. Thus if the drive current of the second pMOS transistor 514 is larger than that of the second nMOS transistor 510, output node 516 cannot be discharged.

In some examples, if a $p$-bit circuit is connected to a level-shifter circuit, an effective capacitance associated with the *p*-bit circuit can increase due to a capacitance associated with the level-shifter circuit. This capacitance increase can slow down transitions associated with the *p*-bit circuit. In some examples, a level-shifter circuit can be associated with a low input capacitance to mitigate this effect. More sophisticated designs of level-shifter circuits involving buffering input stages can also be implemented. For instance, two level-shifter circuits can be used, where the outputs of a first level-shifter circuit could be connected to the inputs of a second level-shifter circuit. In such an implementation, the first level-shifter circuit can have a lower capacitance than the second level-shifter circuit. A *p*-bit can be directly connected to the first level-shifter circuit such that the capacitance of the second level-shifter circuit does not affect the operation of the *p*-bit.

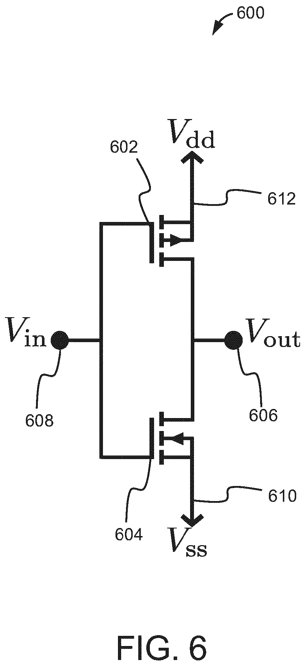

FIG. 6 depicts an example circuit 600 that can be utilized as a noise circuit. The circuit 600 is an example of an inverter circuit. The circuit 600 comprises pMOS transistor 602 and nMOS transistor 604 which share a common drain terminal 606 and gate terminal 608. The device is powered by applying a voltage difference $V_{dd}$ - $V_{ss}$ between the source terminal 610 and the drain terminal 612. When the input voltage $V_{in} < (V_{dd} + V_{ss})/2$, the nMOS transistor 604 becomes an open circuit and $V_{out}$ approaches $V_{dd}$. When $V_{in} > (V_{dd} + V_{ss})/2$, the opposite scenario happens and $V_{out}$ approaches $V_{ss}$.

Without intending to be bound by theory, the following is an example of a theoretical model for illustrating features. The nMOS transistor 604 and pMOS transistor 602 in circuit 600 can be modeled as an externally controlled conduction channel between source and drain, with associated Poisson rates $\lambda_{\pm}^{n}$ and $\lambda_{\pm}^{p}$. The gate-body interface has capacitor $C_g$, and another capacitor $C_o$ takes into account the output capacitance. The transition rates for the nMOS transistor are

$$\lambda_{+}^{n}(q) = (I_0/q_e)e^{(V_{in}-V_{ss}-V_{th})/(nV_T)} \tag{11}$$

$$\lambda_{-}^{n}(q) = \lambda_{+}^{n}(q)e^{-[(q+q_e/2)/(2C_o)+\Delta V/2]/V_T} \tag{12}$$

where $\Delta V = V_{dd}$ - $V_{ss}$. For the pMOS transistor the transition rates are

$$\lambda_{+}^{p}(q) = (I_0/q_e)e^{(V_{dd}-V_{in}-V_{th})/(nV_T)} \tag{13}$$

$$\lambda_{-}^{p}(q) = \lambda_{+}^{p}(q)e^{-[-(q-q_e/2)/(2C_o)+\Delta V/2]/V_T} . \tag{14}$$

The master equation for the distribution $P(q,t)$ can then given by

$$\frac{dP(q,t)}{dt} = P(q-q_e,t)[\lambda_{-}^{n}(q-q_e)+\lambda_{+}^{p}(q-q_e)] + P(q+q_e,t)[\lambda_{+}^{n}(q+q_e)+\lambda_{-}^{p}(q+q_e)]$$

$$-P(q,t)[\lambda_{-}^{n}(q)+\lambda_{+}^{n}(q)+\lambda_{-}^{p}(q)+\lambda_{+}^{p}(q)], \tag{15}$$

which can used to find the steady state of the output node given the voltages $V_{in}$, $V_{dd}$ and $V_{ss}$. Solving eq. (15), a probability distribution describing the voltage at the output mode is at equilibrium when $V_{dd}$ = - $V_{ss}$ = 0 and for practical purposes can be Gaussian. In other words, the distribution is a continuous distribution over a range of voltages and the continuous distribution is substantially Gaussian. When a bias is applied without an input voltage, i.e. $V_{dd}$ = - $V_{ss}$ = $5V_T$, the probability distribution becomes stretched and ceases to be Gaussian. Further, if a small input voltage is applied (say $V_{in}/V_{dd}$ = -0.01), the probability distribution is tilted to one side. A further increase of the input voltage (say $V_{in}/V_{dd}$ = -0.2) generates an approximately Gaussian peak centered around the value corresponding to the deterministic solution.

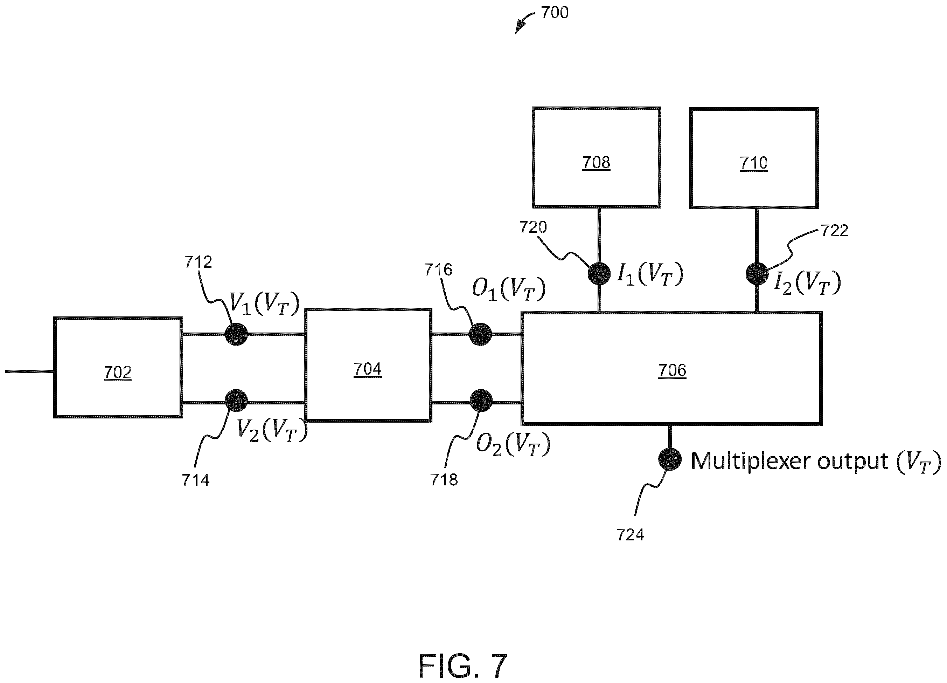

FIG. 7 depicts an example circuit 700 for sampling from two one-dimensional probability distributions. Circuit 700 comprises a *p*-bit circuit 702, a level-shifter circuit 704, a t-gate multiplexer 706, a noise circuit 708 and a noise circuit 710. A node 712, a node 714, a node 716, a node 718, a node 720, a node 722, and a node 724 are also shown. Each of the node 712, the node 714, the node 716, the node 718, the node 720, the node 722, and the node 724 is associated with a respective voltage that can be expressed as a function of a thermal voltage, $V_T$. Specifically, the node 712 is associated with a voltage $V_1(V_T)$, the node 714 is associated with a voltage $V_2(V_T)$, the node 716 is associated with a voltage $O_1(V_T)$, the node 718 is associated with a voltage $O_2(V_T)$, the node 720 is associated with a voltage $I_1(V_T)$, the node 722 is associated with a voltage $I_2(V_T)$, and the node 724 is associated with a voltage $V_{OUT}(V_T)$.

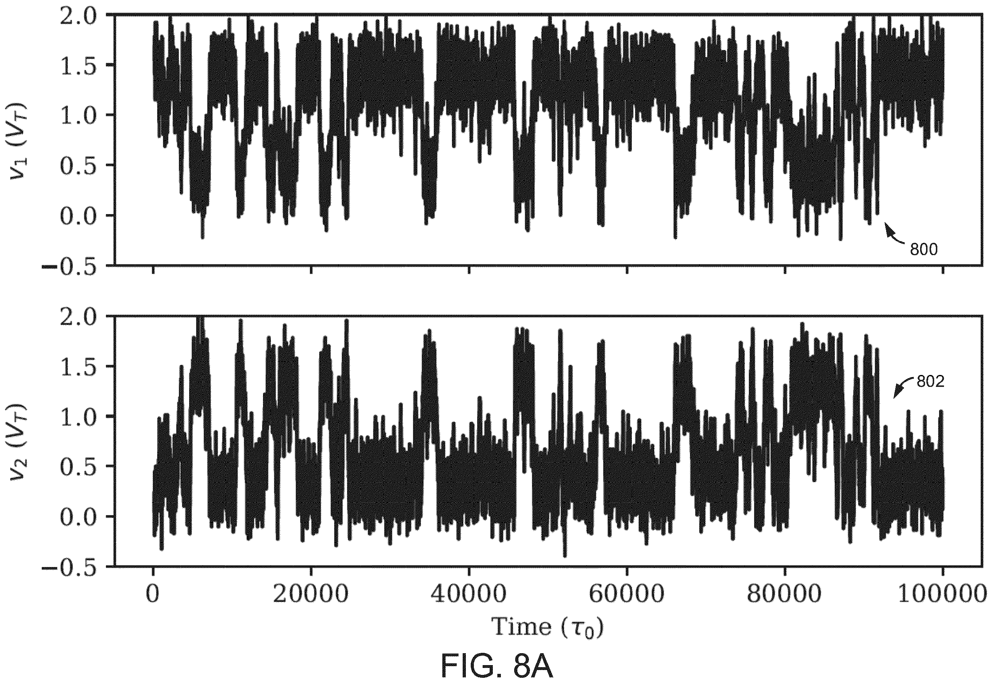

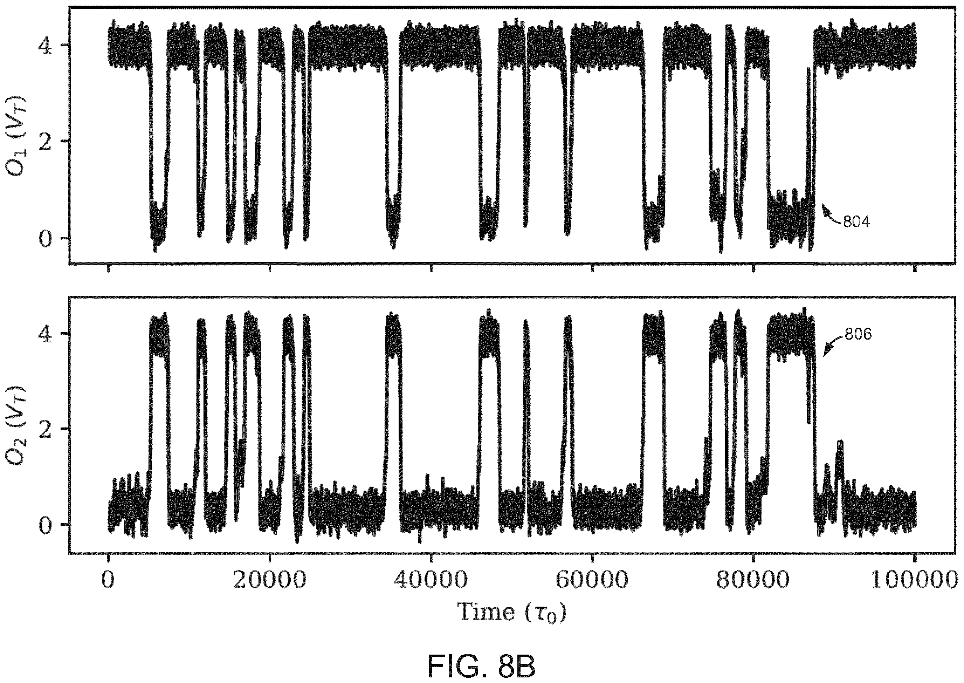

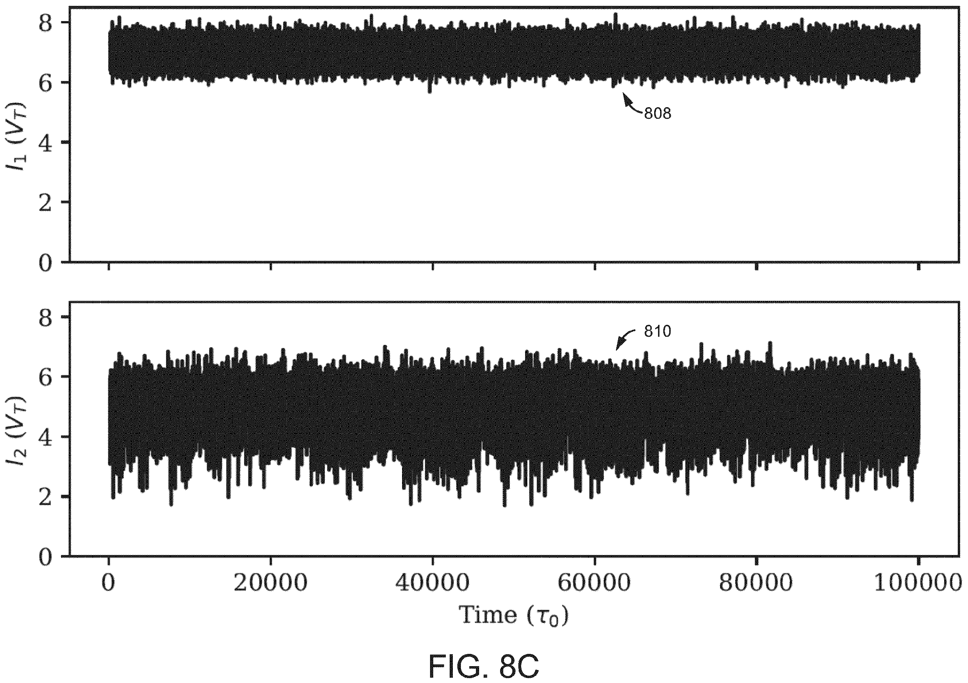

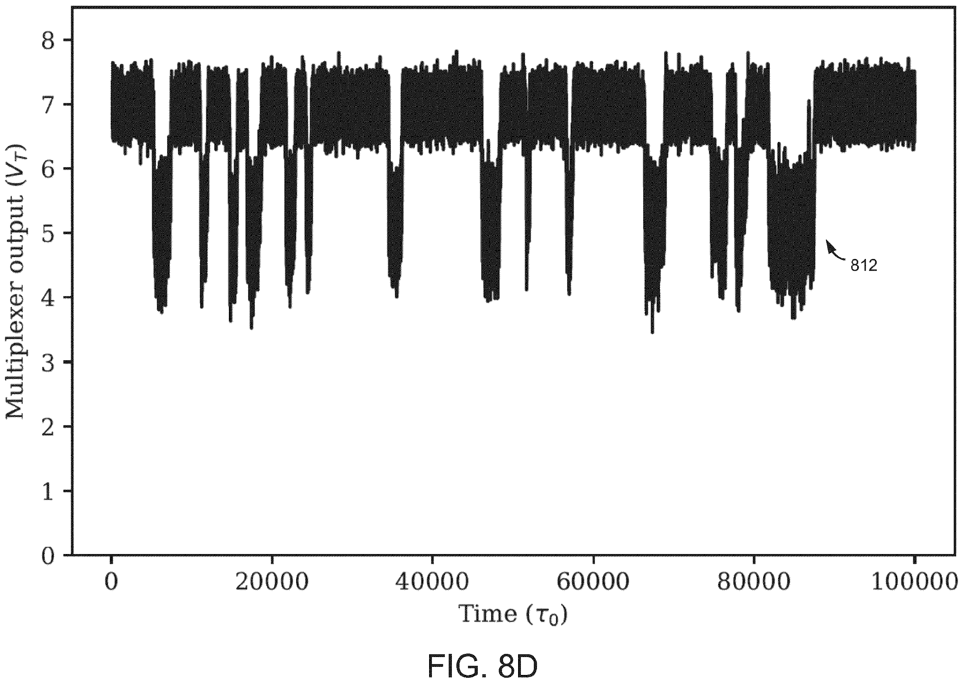

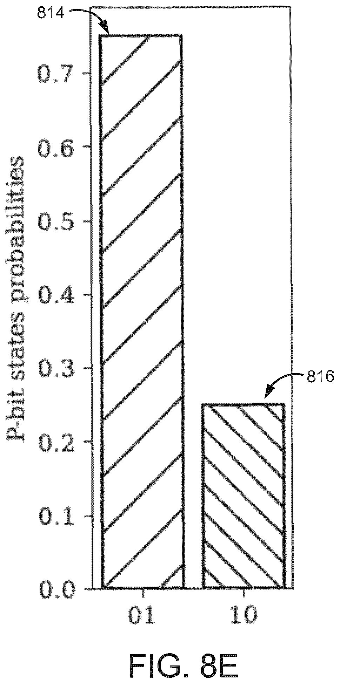

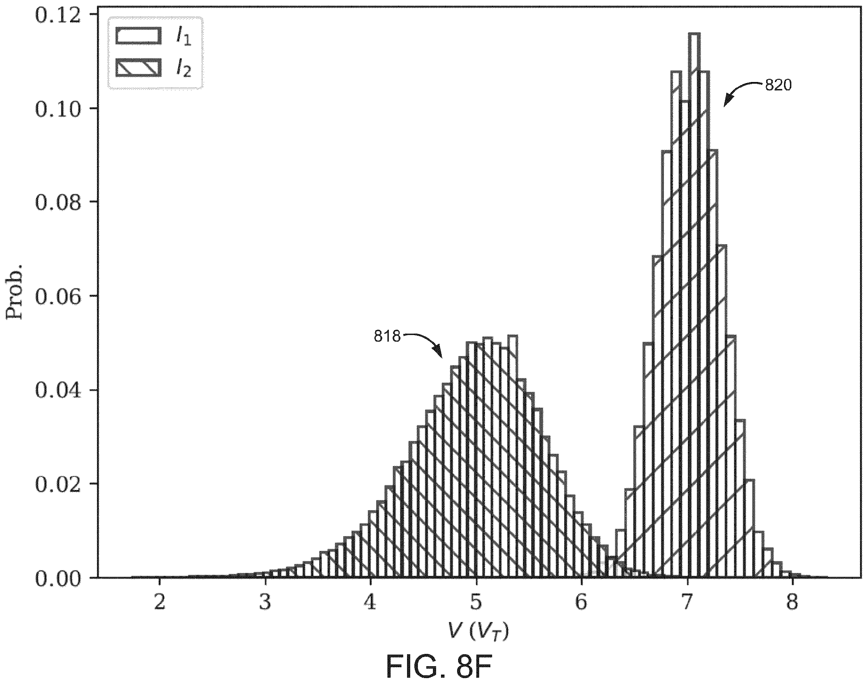

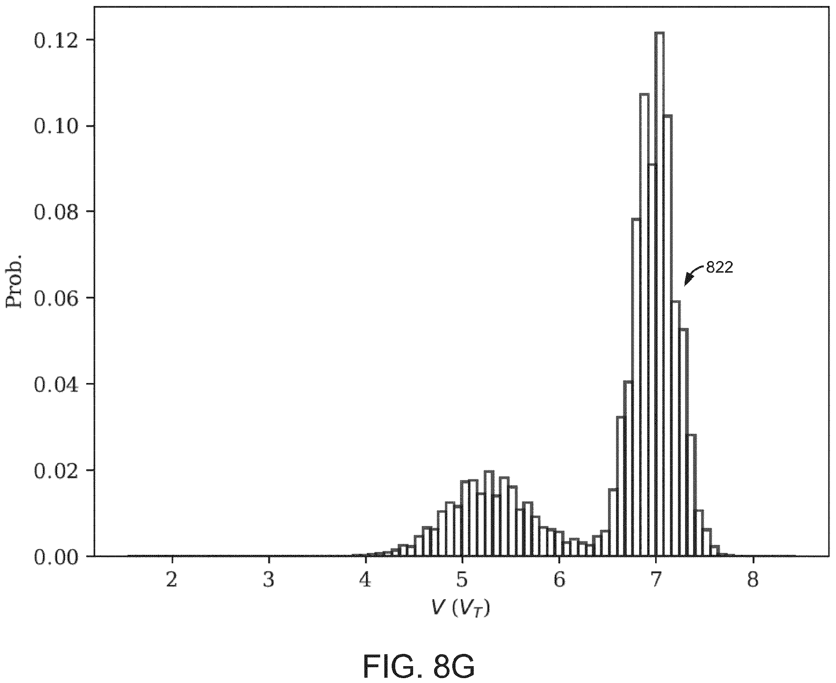

FIGS. 8A-8G depict plots of numerical simulations of voltages at each of the node 712, the node 714, the node 716, the node 718, the node 720, the node 722, and the node 724 in the example circuit 700. FIG. 8A depicts the voltage 800 at the node 712 over time and the voltage 802 at the node 714 over time. FIG. 8B depicts the voltage 804 at the node 716 over time and the voltage 806 at the node 718 over time. FIG. 8C depicts the voltage 808 at the node 720 over time and the voltage 810 at the node 722 over time. FIG. 8D depicts the voltage 812 at the node 724 over time. FIG. 8E depicts a probability 814 associated with the time that the node 712 and the node 716 spend at output state (01) and a probability 816 associated with a time that the node 714 and the node 718 spend at output state (10). FIG. 8F depicts a histogram 818 of the voltages at the node 720 and a histogram 820 of the voltages at the node 722. The histogram 818 and the histogram 820 are both continuous distributions over a range of voltages and the distributions are approximately Gaussian. Each of the histogram 818 and the histogram 820 can be obtained using eq. (15). FIG. 8G depicts a histogram 822 of the voltage at the node 724. The histogram 822 is mixture of the histogram 818 weighted by the probability 814 with the histogram 820 weighted by the probability 816. The histogram 822 is also a continuous distribution over a range of voltages and is a sum of Gaussian distributions, i.e., as shown in eq. (1). As demonstrated by these plots, at a given moment in time, the $p$-bit determines which $t$-gate in the $t$-gate multiplexer is open and which one is short. In other words, the p-bit can be utilized to bias a distribution being sampled.

The following parameters were utilized to generate the plots depicted in FIGS. 8A-8G. Each parameter is expressed in units of the thermal voltage, $V_T = k_b T / q_e$. In some examples, other parameters can be utilized to generate plots or construct and operate devices. $V_{ss} = 0.00 V_T$ is the common ground. $V_{dd} = 1.70 V_T$ powers the metastable circuit.

$V_{dd}^H = 4.00 V_T$ powers the level-shifter. $V_{dd}^{I_1} = 6.00 V_T$ powers the first noise circuit. $V_{in}^{I1} = 3.3 V_T$ is the input voltage for the first noise circuit. $V_{dd}^{I_2} = 7.00 V_T$ powers the second noise circuit. $V_{in}^{I2} = 0.0 V_T$ is the input voltage for the second noise circuit. $V_{bias} = 1.85 V_T$ is the biasing voltage for the metastable circuit. $V_{in} = 0.95 V_T$ is the input voltage for the metastable circuit bias. Each transistor is assumed to have a gate capacitance of 100aF and an output capacitance of 20aF.

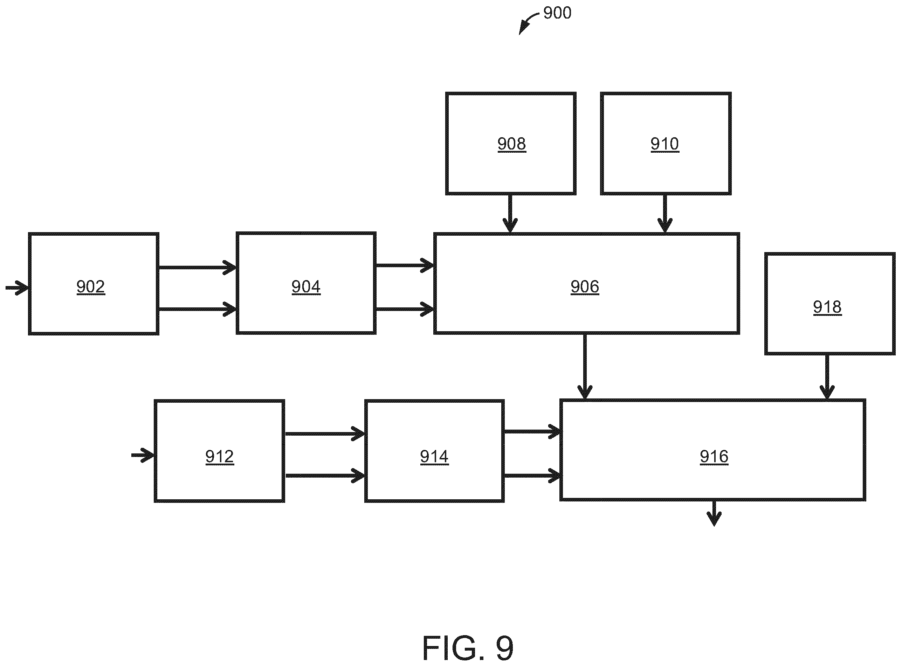

Some circuit architectures can comprise a chain of circuits such that an arbitrary mixture of distributions generated by noise circuits, or probabilistic circuits, can be sampled. FIG. 9 depicts an example circuit architecture 900 that can be used to sample a mixture of three distributions comprising a first metastable circuit 902, a first level-shifter circuit 904, a first mixer circuit 906, a first noise circuit 908, a second noise circuit 910, a second metastable circuit 912, a second level-shifter circuit 914, a second mixer circuit 916, and a third noise circuit 918. Each of the first metastable circuit 902 and the second metastable circuit 912 has inputs to which one or more voltages can be applied. The outputs of the first metastable circuit 902 are connected to the first level-shifter circuit 904, which has outputs connected to the first mixer circuit 906. The outputs of the first noise circuit 908 and the second noise circuit 910 are each connected to the first mixer circuit 906. The first mixer circuit 906 utilizes probabilities associated with the first metastable circuit 902 to mix the distributions associated with each of the first noise circuit 908 and the second noise circuit 910 in order to produce an output distribution. The output distribution of the first mixer circuit is directed to the second mixer circuit 916. The outputs of the second metastable circuit 912 are connected to the second level-shifter circuit 914, which has outputs connected to the second mixer circuit 916. The second mixer circuit 916 utilizes probabilities associated with the second metastable circuit 912 to mix the output distribution of the first mixer circuit 906 with a distribution from the third noise circuit 918 in order to produce an output distribution. The output distribution from the second mixer circuit 916 is thus a mixture of three probability distributions.

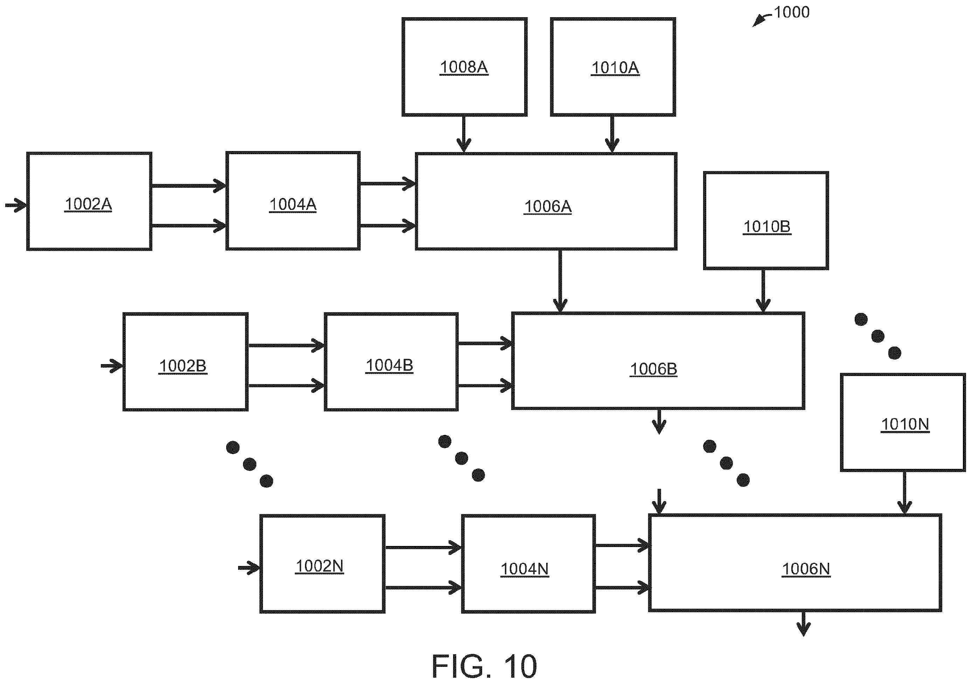

Some circuit architectures can comprise an arbitrary number of circuits, N, in order to sample a mixture of N distributions. FIG. 10 depicts an example circuit architecture 1000 comprising a plurality of metastable circuits 1002A-1002N, i.e., a metastable circuit 1002A, a metastable circuit 1002B, and a metastable circuit 1002N. The circuit architecture 1000 further comprises a plurality of level-shifter circuits 1004A-1004N, i.e., a level-shifter circuit 1004A, a level-shifter circuit 1004B, and a level-shifter circuit 1004N. The circuit architecture 1000 further comprises a plurality of mixer circuits 1006A-1006N, i.e., a mixer circuit 1006A, a mixer circuit 1006B, and a mixer circuit 1006N. The circuit architecture 1000 further comprises a plurality of noise circuits 1008A, 1010A-1010N, i.e., a noise circuit 1008A, a noise circuit 1010A, a noise circuit 1010B, and a noise circuit 1010N. Each metastable circuit in the plurality of metastable circuits 1002A-1002N is configured to produce a bistable state that varies over time between a first stable voltage and a second stable voltage, where a fraction of time that the bistable state spends at the first stable voltage is associated with a first probability. Each mixer circuit of the plurality of mixer circuits 1006A-1006N comprises a first input node, a second input node, a third input node, a fourth input node, and an output node. Each metastable circuit of the plurality of metastable circuits 1002A-1002N is configured to provide one or more signals based at least in part on a produced bistable state to a respective first input node and second input node of a respective mixer circuit of the plurality of mixer circuits 1006A-1006N. In this example circuit architecture 1000, each metastable circuit of the plurality of metastable circuits 1002A-1002N provides the one or more signals based at least in part on a produced bistable state to a respective level-shifter circuit of the plurality of level-shifter circuits 1004A-1004N. Each level-shifter circuit of the plurality of level-shifter circuits 1004A-1004N is configured to shift, i.e., add a reference voltage or or subtract a reference voltage from, the one or more signals based at least in part on a bistable state and provide the shifted signal to a mixer circuit of the plurality of mixer circuits 1006A-1006N. Each mixer circuit of the plurality of mixer circuits 1006A-1006N receives one or more signals based at least in part on a bistable state. Each noise circuit 1010A-1010N of the plurality of noise circuits 1008A, 1010A-1010N is configured to produce a respective voltage distribution to the fourth input node of each mixer circuit of the plurality of mixer circuits 1006A-1006N. The noise circuit 1008A of the plurality of noise circuits 1008A, 1010A-1010N is configured to provide a voltage distribution to the third input node of the mixer circuit 1006A of the plurality of mixer circuits 1006A-1006N.

In some circuit architectures, the plurality of level-shifter circuits might not be necessary and the outputs of each metastable circuit can be directly connected to a respective mixer circuit. In some circuit architectures, some metastable circuits in the plurality of metastable circuits can have outputs that are each connected to a level-shifter circuit.

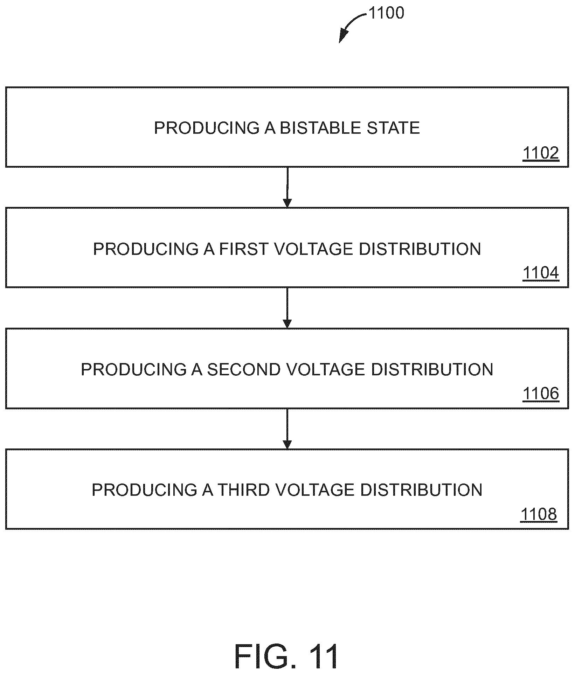

FIG. 11 depicts a flowchart containing an example method 1100. The method 1100 comprises producing 1102 a bistable state that varies over time between a first stable voltage and a second stable voltage, where a fraction of time that the bistable state spends at the first stable voltage is associated with a first probability. In some examples, this bistable state can be produced by a metastable circuit. The method 1100 further comprises producing 1104 a first voltage distribution. In some examples, the first voltage distribution can be produced by a noise circuit. The method 1100 further comprises producing 1106 a second voltage distribution. In some examples, the second voltage distribution can be produced by a noise circuit. The method 1100 further comprises producing 1108 a third voltage distribution that is based at least in part on the bistable state, the first voltage distribution, and the second voltage distribution. In some examples, the third voltage distribution can be produced using a mixer circuit and this step can be referred to as "mixing" voltage distributions.

In some implementations, a circuit architecture can be formed as part of a system. A system can be implemented in various configurations, including as a single apparatus or as a combination of one or more apparatuses that collectively perform the functions of a system. In some examples, the one or more apparatuses can form a device, i.e., a system-on-a-chip, or the one or more apparatuses can be separate devices.

In some implementations, a system can be formed from one or more integrated circuit (IC) chips comprising portions of a circuit architecture. Some circuit architectures can be distributed across multiple chips or consolidated onto a single chip. Some chips can comprise multiple layers of material. In some examples, portions of a circuit architecture can be formed across several layers of devices.

Some systems can comprise analog, digital, or mixed-signal circuitry configured to perform functions such as signal processing, voltage regulation, or data acquisition. Some systems can comprise interface or control circuitry configured to perform functions such as applying bias voltages, measuring voltages, or interfacing with components of the circuit. In some examples, control circuitry can be implemented in one or more dedicated regions of an IC, or distributed throughout a circuit architecture. In some examples, control circuitry can comprise components such as a field-programmable gate array (FPGA), an application specific integrated circuit (ASIC), one or more processors or processor cores, including central processing unit(s) (CPU(s)) and/or graphics processing unit(s) (GPU(s)), or other computing devices or modules capable of executing a program (e.g., software and/or firmware) comprising instructions or other compiled or executable code. The electronic circuitry can also include at least one data storage system (e.g., including volatile and non-volatile memory, and/or storage media). The program may be provided on a computer-readable storage medium, or delivered over a communication medium such as a wired or wireless network, to a device module where it can be stored and eventually executed when read by the device to perform the procedures of the program.

In some implementations, portions of a circuit architecture and control circuitry can be arranged in a flip-chip configuration to allow for three-dimensional integration of multiple chips or substrates. Some flip-chip configurations comprise conductive structure such as wire bonds, microbumps, or vias to facilitate electrical communication between multiple layers or chips.

While the disclosure has been described in connection with certain embodiments, it is to be understood that the disclosure is not to be limited to the disclosed embodiments but, on the contrary, is intended to cover various modifications and equivalent arrangements included within the scope of the appended claims, which scope is to be accorded the broadest interpretation so as to encompass all such modifications and equivalent structures as is permitted under the law.

**Claims**

1. An apparatus comprising:

   a first metastable circuit configured to produce a bistable state that varies over time between a first stable voltage and a second stable voltage, where a fraction of time that the bistable state spends at the first stable voltage is associated with a first probability;
   a first noise circuit configured to produce a first voltage distribution;
   a second noise circuit configured to produce a second voltage distribution; and
   a mixer circuit configured to receive the first voltage distribution, the second voltage distribution, and one or more signals based at least in part on the bistable state;
   wherein the mixer circuit is configured to produce a third voltage distribution that is based at least in part on the one or more signals associated with the bistable state, the first voltage distribution, and the second voltage distribution.

2. The apparatus of claim 1, wherein the first metastable circuit is configured to produce the bistable state based at least in part on a bias voltage applied to the first metastable circuit.

3. The apparatus of claim 1 or 2, wherein each of the first noise circuit and the second noise circuit comprises an inverter circuit.

4. The apparatus of claim 1, 2 or 3, wherein the one or more signals based at least in part on the bistable state comprise, at a given time, a signal based at least in part on the first stable voltage and a signal based at least in part on the second stable voltage.

5. The apparatus of any one of claims 1 to 4, wherein the mixer circuit comprises two active switching elements, where each active switching element of the two active switching elements is configured to act as a switch in the mixer circuit based on a respective applied voltage.

6. The apparatus of claim 5, wherein each active switching element of the two active switching elements comprises one or both of a p-type metal-oxide-semiconductor transistor or an n-type metal-oxide-semiconductor transistor and the respective applied voltage applied to each active switching element of the two active switching elements is lower than a threshold voltage of the one or both of the p-type metal-oxide-semiconductor transistor or the n-type metal-oxide-semiconductor transistor associated with the each active switching element of the two active switching elements.

7. The apparatus of any one of claims 1 to 6, further comprising

a plurality of metastable circuits including the first metastable circuit, wherein each metastable circuit of the plurality of metastable circuits is configured to produce a bistable state that varies over time between a first stable voltage and a second stable voltage, where a fraction of time that the bistable state spends at the first stable voltage is associated with a first probability;
a plurality of noise circuits including the first noise circuit and the second noise circuit, wherein each noise circuit of the plurality of noise circuits is configured to produce a respective voltage distribution; and
a plurality of mixer circuits configured to receive one or more voltage distributions and one or more signals based at least in part on a bistable state and produce a voltage distribution based at least in part on the one or more voltage distributions and the one or more signals based at least in part on a bistable state;
wherein each mixer circuit of the plurality of mixer circuits receives a respective voltage distribution from a noise circuit of the plurality of noise circuits;
wherein a first mixer circuit of the plurality of mixer circuits receives one or more signals based at least in part on the bistable state from the first metastable circuit of the plurality of metastable circuits and the first mixer circuit of the plurality of mixer circuits receives a voltage distribution from a noise circuit of the plurality of noise circuits;
wherein each other mixer circuit of the plurality of mixer circuits is configured to receive one or more signals based at least in part on a bistable state from a respective metastable circuit of the plurality of metastable circuits;
wherein each other mixer circuit of the plurality of mixer circuits receives an output from another mixer circuit of the plurality of mixer circuits.

8. The apparatus of any one of claims 1 to 7, wherein each noise circuit is configured to produce a respective voltage distribution that is substantially Gaussian.

9. The apparatus of any one of claims 1 to 8, wherein each metastable circuit is connected to a respective level-shifter circuit configured to add a reference voltage to or subtract a reference voltage from the one or more signals based on the bistable state.

10. A method comprising:

producing, using a first metastable circuit, a bistable state that varies over time between a first stable voltage and a second stable voltage, where a fraction of time that the bistable state spends at the first stable voltage is associated with a first probability;
producing, using a first noise circuit, a first voltage distribution;
producing, using a second noise circuit, a second voltage distribution; and

producing, using a first mixer circuit, a third voltage distribution that is based at least in part on the bistable state, the first voltage distribution, and the second voltage distribution.

11. The method of claim 10, further comprising

producing, using a plurality of metastable circuits including the first metastable circuit, a plurality of bistable states, where each bistable state of the plurality of bistable states varies over time between a respective first stable voltage and a respective second stable voltage, where a fraction of time that the each bistable state of the plurality of bistable states spends at the first stable voltage is associated with a first probability, and
producing, using a plurality of noise circuits including the first noise circuit and the second noise circuit, a first plurality of voltage distributions; and
producing, using a plurality of mixer circuits including the first mixer circuit, a second plurality of voltage distributions, where each voltage distribution in the second plurality of voltage distributions is based at least in part on a bistable state of the plurality of bistable states, a voltage distribution from the first plurality of voltage distributions, and a voltage distribution produced by another mixer circuit of the plurality of mixer circuits.

12. The method of claim 10 or claim 11, wherein each noise circuit is configured to produce a voltage distribution that is substantially Gaussian.

13. The method of claim 10 or claim 11, wherein each metastable circuit is connected to a respective level-shifter circuit configured to add a reference voltage to or subtract a reference voltage from one or more signals based on the bistable state.

14. The method of claim 11, wherein each mixer circuit of the plurality of mixer circuits comprises two active switching elements, where each active switching element of the two active switching elements is configured to act as a switch in the mixer circuit based on a respective voltage applied to each active switching element of the two active switching elements.

15. The method of claim 14, wherein each active switching element of the two active switching elements comprises one or both of a p-type metal-oxide-semiconductor transistor, or an n-type metal-oxide-semiconductor transistor and the respective voltage applied to each active switching element of the two active switching elements is lower than a threshold voltage of the one or both of the p-type metal-oxide-semiconductor transistor or the n-type metal-oxide-semiconductor transistor associated with the each active switching element of the two active switching elements.

FIG. 1A

EP 4 687 288 A1

EP 4 687 288 A1

100B

114B   116B

110B   112B

104B   122

102B   120   108B

106B   124

118B

FIG. 1B

FIG. 2A

EP 4 687 288 A1

FIG. 2B

EP 4 687 288 A1

FIG. 2C

200D

256 — $V_{out}^1$
258 — $V_{out}^2$

N-Level shifter

P-Level shifter

260 — $V_b^p$

Single-ended to diff converter

262 — $V_b^n$

Noise generator

252 — $V_{in}^p$
254 — $V_{in}^n$

FIG. 2D

FIG. 3A

FIG. 3B

FIG. 3C

FIG. 3D

FIG. 3E

EP 4 687 288 A1

FIG. 4

EP 4 687 288 A1

EP 4 687 288 A1

FIG. 5

FIG. 6

FIG. 7

FIG. 8A

FIG. 8B

EP 4 687 288 A1

FIG. 8C

FIG. 8D

FIG. 8E

FIG. 8F

FIG. 8G

FIG. 9

FIG. 10

EP 4 687 288 A1

```
                              1100

        ┌─────────────────────────────────────────┐
        │                                         │
        │      PRODUCING A BISTABLE STATE          │
        │                                         │
        │                              1102        │
        └─────────────────────────────────────────┘
                           │
                           ▼
        ┌─────────────────────────────────────────┐
        │                                         │
        │   PRODUCING A FIRST VOLTAGE DISTRIBUTION │
        │                                         │
        │                              1104        │
        └─────────────────────────────────────────┘
                           │
                           ▼
        ┌─────────────────────────────────────────┐
        │                                         │
        │  PRODUCING A SECOND VOLTAGE DISTRIBUTION │
        │                                         │
        │                              1106        │
        └─────────────────────────────────────────┘
                           │
                           ▼
        ┌─────────────────────────────────────────┐
        │                                         │
        │   PRODUCING A THIRD VOLTAGE DISTRIBUTION │
        │                                         │
        │                              1108        │
        └─────────────────────────────────────────┘
```

FIG. 11

Europäisches
Patentamt

European
Patent Office

Office européen
des brevets

# EUROPEAN SEARCH REPORT

**Application Number**

EP 25 19 0660

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/202953 A1 (CHEN NAN [US] ET AL) 14 July 2016 (2016-07-14) * paragraph [0054] - paragraph [0061]; figures 12-15 * * paragraph [0091] - paragraph [0103] * ----- | 1-4,7-13 | INV. H03K3/037 H03K19/094 G06F7/58 |
| X | US 8 489 660 B2 (HERBERT HOWARD C [US]; COX GEORGE W [US] ET AL.) 16 July 2013 (2013-07-16) * column 4, line 22 - line 30; figure 4 * ----- | 1-3,10 | |
| X | JP 3 149771 B2 (NEC CORP) 26 March 2001 (2001-03-26) * paragraph [0026] - paragraph [0034]; figures 2-6 * ----- | 1-3,5,6, 10,14,15 | |

**TECHNICAL FIELDS SEARCHED (IPC)**

G06F
H04L
H03K

The present search report has been drawn up for all claims

| Place of search | Date of completion of the search | Examiner |
|---|---|---|
| Munich | 8 December 2025 | Mesplede, Delphine |

EPO FORM 1503 03.82 (P04C01)

## ANNEX TO THE EUROPEAN SEARCH REPORT
## ON EUROPEAN PATENT APPLICATION NO.

EP 25 19 0660

This annex lists the patent family members relating to the patent documents cited in the above-mentioned European search report.
The members are as contained in the European Patent Office EDP file on
The European Patent Office is in no way liable for these particulars which are merely given for the purpose of information.

08-12-2025

| Patent document cited in search report | Publication date | Patent family member(s) | | Publication date |
|---|---|---|---|---|
| US 2016202953 A1 | 14-07-2016 | CN | 107111480 A | 29-08-2017 |
| | | EP | 3245584 A2 | 22-11-2017 |
| | | EP | 3422175 A1 | 02-01-2019 |
| | | JP | 2018507468 A | 15-03-2018 |
| | | US | 2016202953 A1 | 14-07-2016 |
| | | WO | 2016140723 A2 | 09-09-2016 |
| US 8489660 B2 | 16-07-2013 | NONE | | |
| JP 3149771 B2 | 26-03-2001 | JP | 3149771 B2 | 26-03-2001 |
| | | JP | H09214298 A | 15-08-1997 |

EPO FORM P0459

For more details about this annex : see Official Journal of the European Patent Office, No. 12/82

**REFERENCES CITED IN THE DESCRIPTION**

**Patent documents cited in the description**

- US 63676547